# EUROPEAN PATENT APPLICATION

(11) **EP 3 621 125 A1**
(43) Date of publication of application: **11.03.2020**
(21) Application number: 18759538.4
(22) Date of filing: 20.08.2018
(51) Int. Cl.: H01L 31/0392, H01L 31/18

(54) **CIGS SOLAR CELL AND PREPARATION METHOD THEREOF**

(30) Priority: 27.06.2018 CN 201810680554
(71) Applicant: Beijing Apollo Ding Rong Solar Technology Co. Ltd., Beijing 100176 (CN)
(72) Inventor: ZHANG, Liqiang, Beijing 100176 (CN)
(74) Representative: Broderick, Terence
(86) International application number: PCT/CN2018/101224
(87) International publication number: WO 2020/000599

(57) **Abstract**

The present disclosure relates to the field of energy technology, and discloses a CIGS solar cell and a preparation method thereof. In some embodiments of the present disclosure, the method for preparing the CIGS solar cell comprises: forming a back electrode layer and a CIGS layer sequentially on a surface of a substrate; etching a surface of the CIGS layer, and performing cleaning, drying and annealing treatments after the etching is completed; and forming a buffer layer, a window layer and a transparent electrode layer sequentially on a surface of the annealed CIGS layer after the annealing treatment. The CISG solar cell and the preparation method thereof as provided by some embodiments of the present can improve photoelectric conversion performance of the CIGS solar cell and increase conversion efficiency of the CIGS solar cell.

## Description

### CROSS REFERENCE TO RELATED APPLICATIONS

The present disclosure claims the benefit of Chinese application No. 201810680554.9 with an invention title of "CIGS SOLAR CELL AND PREPARATION METHOD THEREOF" filed on June 27, 2018, which is hereby incorporated by reference in its entirety.

### TECHNICAL FIELD

The present disclosure relates to the field of energy technology, and particularly relates to a CIGS solar cell and a method for preparing the CIGS solar cell.

### BACKGROUND

Since the first CIS (Cu-In-Se) thin film solar cell in the world was prepared by Wanger et al in 1974, CIS solar cell and CIGS (CuInₓGa₍₁₋ₓ₎Se₂) solar cell have attracted wide attention from researchers in the photovoltaic industry because of their stable performance under sunlight, strong radiation resistance, large improvement potential in conversion efficiency, and possibility of being deposited on a flexible substrate, etc.

### SUMMARY

Some embodiments of the present disclosure aim to provide a CIGS solar cell and a method for preparing the CIGS solar cell, which can improve photoelectric conversion performance of the CIGS solar cell and increase conversion efficiency of the CIGS solar cell.

In order to solve the above technical problems, some of the embodiments of the present disclosure provide a method for preparing a CIGS solar cell, comprising:
forming a back electrode layer and a CIGS layer sequentially on a surface of a substrate;
etching a surface of the CIGS layer, and then performing cleaning, drying and annealing treatments after the etching is completed; and
forming a buffer layer, a window layer and a transparent electrode layer sequentially on an annealed surface the CIGS layer after annealing treatment.

In some embodiments, the step of etching a surface of the CIGS layer, and performing cleaning, drying and annealing after the etching is completed comprises:
dipping a laminated structure, which including the substrate, the back electrode layer and the CIGS layer, into an etchant for etching; and
cleaning with deionized water, and then drying and annealing under an inert atmosphere after the etching is completed.

In some embodiments, the surface of the CIGS layer is perpendicular to a liquid surface of the etchant during the etching process. As such, when the laminated structure is taken out from the etchant in a direction perpendicular to the liquid surface (i.e., a vertical direction), the etchant at the surface of the CIGS layer will move relative to the surface of the CIGS layer under the action of gravity, so that the etchant can flush impurity on the surface of the CIGS layer in the vertical direction, thereby reducing impurity residue on the surface of the CIGS layer.

In some embodiments, the etchant is selected from a bromine-methanol solution and/or a potassium cyanide solution, and an etching time ranges from 30s to 90s. When an etching duration is within this range, it can not only ensure that a part of the CIGS layer is etched to remove a binary impurity phase at the surface, but also prevent excessive etching of the CIGS layer from affecting photoelectric conversion performance of the solar cell.

In some embodiments, when the etchant comprises the bromine-methanol solution, a volume ratio of bromine water to methanol in the bromine-methanol solution is 1∼10: 90∼99. When the volume ratio of bromine water to methanol in the bromine-methanol solution is within this range, it not only avoids excessive etching to the CIGS layer due to too high concentration which causes too fast etching, but also avoids a reduction of production efficiency due to too low concentration which causes too slow etching, so that the etching rate may be kept within an appropriate range, and production efficiency is improved while quality of the CIGS solar cell is ensured.

In some embodiments, when the etchant comprises the bromine-methanol solution, a volume ratio of bromine water to methanol in the bromine-methanol solution is 5: 95.

In some embodiments, when the etchant comprises the potassium cyanide solution, a molar concentration of the potassium cyanide solution ranges from 0.05 mol/L to 0.5 mol/L.

In some embodiments, when the etchant comprises the potassium cyanide solution, a molar concentration of the potassium cyanide solution is 0.1 mol/L.

In some embodiments, an annealing temperature ranges from 150° C to 500° C, and an annealing time ranges from 20 min∼40 min.

In some embodiments, there is further provided a CIGS solar cell prepared by the preparation method of the CIGS solar cell as described above.

As compared with the existing technology, some embodiments of the present disclosure is added with a step of processing the CIGS layer during the preparing process of the CIGS solar cell, i.e., the step of etching the surface of the CIGS layer with the etchant. In the existing technology, it is inevitable to form the binary impurity phase which has not been completely reacted on the surface of the CIGS layer when preparing the CIGS layer, while with the step of etching the surface of the CIGS layer with the etchant, the present disclosure can well remove the binary impurity phase that influences performance of the CIGS solar cell. In addition, after the etching is completed, cleaning, drying and annealing treatments are performed to facilitate subsequent formation of the buffer layer, the window layer and the transparent electrode layer on the CIGS layer, thereby forming a complete solar cell structure. The annealing treatment is beneficial to crystallization of the surface of the CIGS layer. The photoelectric conversion performance of the CIGS solar cell can be improved and the conversion efficiency of the CIGS solar cell can be increased due to elimination of the binary impurity phase and improvement of surface crystallization of the CIGS layer.

### BRIEF DESCRIPTION OF THE DRAWINGS

One or more embodiments are exemplified by figures in the accompanying drawings corresponding thereto, these exemplary description shall not be construed as limiting the embodiments, elements having the same reference numerals in the figures represent similar elements, unless explicitly stated otherwise, the figures shall not be considered as drawn to scale.
FIG. 1 is a schematic flow chart of a method for preparing a CIGS solar cell provided by some embodiments of the present disclosure; and
FIG. 2 is a schematic structural diagram of a CIGS solar cell provided by some embodiments of the present disclosure.

### DETAILED DESCRIPTION

For objectives, technical solutions and advantages of the embodiments of the present disclosure to be clearer, the respective embodiments of the present disclosure will be described in detail below with reference to the accompanying drawings. However, as will be understood by a person of ordinary skill in the art, in the respective embodiments of the present disclosure, numerous technical details are set forth for the reader to better understand the present disclosure. The technical solutions claimed in the present disclosure can also be implemented without these technical details and various changes and modifications made to the respective embodiments provided below.

Generally, a conventional CIGS solar cell is of a substrate SLG/bottom electrode Mo/absorption layer CIGS/buffer layer CdS/window layer i-ZnO (intrinsic zinc oxide)/transparent conductive layer AZO (aluminum-doped zinc oxide) structure. At present, a maximum conversion efficiency of the cell with this structure in small-area laboratory has exceeded 22%.

In the process of implementing some embodiments of the present disclosure, the inventor finds that: the absorption layer (i.e., the CIGS layer) of the conventional CIGS solar cell is mainly prepared by employing two methods, that is, a co-evaporation method, or a sputtering followed by selenization method; formation and decomposition of many binary and ternary impurity phases may be formed and decomposed concomitantly during the preparation process, which may affect performance of the CIGS solar cells, resulting in low conversion efficiency of the CIGS solar cell. Therefore, some embodiments of the present disclosure provide a new method for preparing the CIGS solar cell and the CIGS solar cell prepared by the aforesaid method so as to overcome the above problem.

Some embodiments of the present disclosure relate to a method for preparing the CIGS solar cell, comprising: forming a back electrode layer and a CIGS layer sequentially on a surface of a substrate; etching a surface of the CIGS layer, and performing cleaning, drying and annealing treatments after the etching is completed; and forming a buffer layer, a window layer and a transparent electrode layer sequentially on a surface of the annealed CIGS layer.

In the CIGS solar cell, Cu content directly affects types and states of the binary impurity phases. Among the binary impurity phases of CIGS crystal, there are many types of copper selenium compound, such as Cu₃Se₂, CuSe, CuSe₂, Cu₂Se(Cu₂₋ₓSe) and the like. The copper selenium compound generally has strong electrical conductivity, wherein Cu₂₋ₓSe is the most negative and most difficult one to control.
1) Cu₂₋ₓSe has two types of conductive mechanisms, i.e., ion and electron conductive mechanisms, and usually exists at the surface of the CIGS thin film and a grain interface. A second phase exists between the grains, which may effectively prevent the carriers from moving between the grains and reduce efficiency of the carriers. Meanwhile, the second phase is a strong recombination center, which may increase carrier recombination at the interface, thereby causing cell leakage and resulting in a drop of a cell fill factor.
2) Cu₂₋ₓSe is a good conductor; when the thin film contains the Cu₂₋ₓSe binary phase, electrical property of the thin film greatly changes, resistivity and mobility greatly decrease, while carrier concentration may increase by 2 to 3 orders of magnitude, so that semiconductor property of the film is weakened whereas metallicity thereof is enhanced. As the Cu₂₋ₓSe increases, the CIGS film may eventually transform into a conductor, and completely loses the semiconductor property.
3) During the selenization process, Cu₂₋ₓSe gradually moves to the surface of the CIGS film, which causes heterogeneous distribution of surface stress on the surface of the film, thereby affecting adhesion of the film.

Some embodiments of the present disclosure is added with a step of processing the CIGS layer during the preparing process of the CIGS solar cell, i.e., the step of etching the surface of the CIGS layer with the etchant. In the existing technology, it is inevitable to form the binary impurity phase which has not been completely reacted on the surface of the CIGS layer when preparing the CIGS layer, while with the step of etching the surface of the CIGS layer with the etchant, the some embodiments of the present disclosure can well remove the binary impurity phase that influences performance of the CIGS solar cell. In addition, after the etching is completed, cleaning, drying and annealing treatments are performed to facilitate subsequent formation of the buffer layer, the window layer and the transparent electrode layer on the CIGS layer, thereby forming a complete solar cell structure. The annealing treatment is beneficial to crystallization of the surface of the CIGS layer. The photoelectric conversion performance of the CIGS solar cell can be improved and the conversion efficiency of the CIGS solar cell can be increased due to elimination of the binary impurity phase and improvement of surface crystallization of the CIGS layer.

Hereinafter, implementation details of the method for preparing the CIGS solar cell according to some embodiments of the present disclosure will be described below, the following content is merely implementation details provided for facilitating understanding, not necessity to implement the solutions thereof.

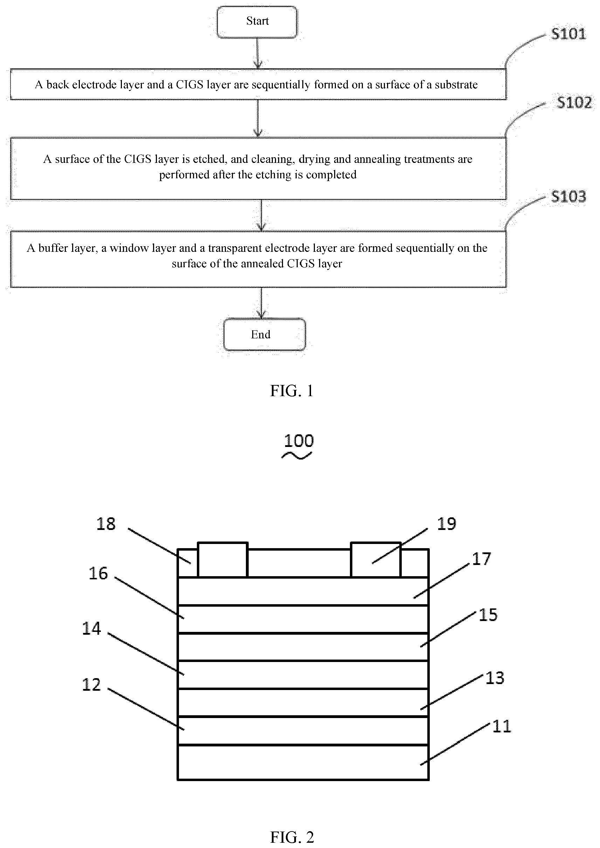

Fig. 1 shows the method for preparing the CIGS solar cell in some embodiments of the present disclosure, and FIG. 2 shows the prepared CIGS solar cell 100. The preparation method specifically comprises the following steps.

In step S101, a back electrode layer 13 and a CIGS layer 14 are sequentially formed on a surface of a substrate 11. In this embodiment, a support layer 12 is further deposited between the substrate 11 and the back electrode layer 13.

In step S101, the substrate 11 may be degreased soda lime glass having a thickness of 0.55 mm and a length and width of 10 mm ×10 mm. It should be noted that, the substrate 11 in some embodiments of the present disclosure may also be a stainless steel, or a flexible substrate such as an organic polymer substrate.

The support layer 12 may be formed by sputtering on the substrate 11 using a magnetron sputtering device. Specifically, in this embodiment, a Ar gas may be used as a discharge gas, and a silicon aluminum (a silicon to aluminum mass ratio is Si:Al=98:2) is used as a target, a working gas is N₂, and a sputtering pressure is 0.5 Pa, a radio frequency (RF) power source is adopted, Si₃N₄ is deposited on the substrate 11 as the support layer 12, and a thickness of the support layer 12 is in a range of 0.02 µm to 0.1 µm. For example, a thickness of the support layer is 0.05 µm.

It should be noted that, in some embodiments of the present disclosure, the support layer 12 may be made of other nitride materials than Si₃N₄, such as titanium nitride, tantalum nitride, etc., or may be of an oxide such as titanium oxide, zinc oxide, tin oxide, silicon oxide, aluminum-doped zincoxide, etc., or may be of a metal such as Mo, Cr, Cu, Ni, a nickel-chromium alloy NiCr, Nb and other metals.

The back electrode layer 13 may be formed by sputtering on the support layer 12 using a magnetron sputtering device. Specifically, in some embodiments of the present disclosure, the discharge gas is Ar gas, the sputtering pressure is 0.1 to 1 Pa, for example, the sputtering pressure is 0.5 Pa, a direct current (DC) power source is adopted, and the back electrode layer 13 is deposited on the support layer 12. The back electrode layer 13 may be a Mo layer having a thickness in a range of 0.3 µm to 0.7 µm, for example, the Mo layer has a thickness of 0.5 µm.

The CIGS layer 14 may be formed on the back electrode layer 13 by using a vacuum evaporation technique. The CIGS layer 14 can absorb solar energy and convert solar energy into electrical energy. Specifically, in this embodiment, Cu, In, Se and Ga may be respectively configured as a vapor deposition source in a chamber of a vacuum evaporation device, wherein a mass percentage of Cu is 20% to 30%, a mass percentage of In 15% to 25%, a mass percentage of Ga is 5% to 15%, and a mass percentage of Se is 40% to 60%. For example, a mass ratio of each element is Cu: In: Ga: Se=23.5: 19.5: 7: 50. The absorption layer, i.e., the CIGS layer 14, is prepared on the back electrode layer 13 by a three step co-evaporation method. The obtained CIGS layer 14 has a thickness in a range of 1.5 µm to 2.5 µm, for example, the CIGS layer 14 has a thickness of 2 µm.

It should be noted that, in some embodiments of the present disclosure, the CIGS layer 14 may be prepared by employing a co-sputtering method, such as a magnetron co-sputtering method, which process is similar to the formation process of the support layer 12 and the back electrode layer 13 described above. In order to avoid repetition of content, no details are described herein.

In step S102, a surface of the CIGS layer 14 is etched, and cleaning, drying, and annealing treatments are performed after the etching is completed.

In some embodiments of the present disclosure, a laminated structure that comprises the substrate 11, the back electrode layer 13 and the CIGS layer 14 may be dipped in an etchant for etching; after the etching is completed, the laminated structure is washed with deionized water, followed by dried and annealed under an inert atmosphere.

It is worth mentioning that, during the etching process, the surface of the CIGS layer 14 is perpendicular to a liquid surface of the etchant. As such, when the laminated structure is taken out from the etchant in a direction perpendicular to the liquid surface (i.e., a vertical direction), the etchant at the surface of the CIGS layer 14 may move relative to the surface of the CIGS layer 14 under the action of gravity, so that the etchant can wash impurity on the surface of the CIGS layer 14 in the vertical direction, thereby reducing impurity residue on the surface of the CIGS layer 14.

Specifically, in some embodiments of the present disclosure, an etching time is 30s∼90s. When the etching time is within this range, it can not only ensure that a part of the CIGS layer 14 can be etched away to remove the binary impurity phase (mainly a copper selenium compound) on the surface, but also prevent excessive etching of the CIGS layer 14 to such an extent as to affect performance of the solar energy cell. For example, the etching time is 60s.

It is worth mentioning that, the etchant used in the etching process may be a bromine-methanol solution. A volume ratio of bromine water to methanol in the bromine-methanol solution is 1∼10: 90∼99. When the volume ratio of bromine to methanol in the bromine-methanol solution is within this range, it not only avoids excessive etching to the CIGS layer 14 due to too high concentration which causes too fast etching, but also avoids a reduction of production efficiency due to too low concentration which causes too slow etching, so that the etching rate may be within an appropriate range, and production efficiency is improved while quality of the CIGS solar cell is ensured. For example, the volume ratio of the volume ratio of bromine to methanol in the bromine-methanol solution is 5: 95.

In some embodiments of the present disclosure, the following chemical reactions occur between the bromine-methanol solution and the copper selenium compound:

Br₂+Cu₂₋ₓSe → CuBr₂+Se;

Se+ Br₂ → SeBr₄;

wherein SeBr₄ is dissolved in the CH₃OH (methanol) solution.

It can be understood that, after the laminated structure is etched by the bromine-methanol solution, the copper selenide compound (mainly the Cu₂₋ₓSe) on the surface of the CIGS layer 14 of the laminated structure chemically reacts with the bromine in the bromine-methanol solution, to form CuBr₂ and SeBr₄ capable of being dissolved in the bromine-methanol solution. As such, the copper selenium compound on the surface of the CIGS layer 14 can be removed, which helps to improve photoelectric conversion performance of the CIGS solar cell and increase conversion efficiency of the solar cell.

It is worth mentioning that, the etchant may be a potassium cyanide (KCN) solution. A molar concentration of the potassium cyanide solution is 0.05mol/L∼0.5mol/L. When the molar concentration of the potassium cyanide in the potassium cyanide solution is within this range, it not only avoids excessive etching of the CIGS layer 14 caused by too fast etching due to too high concentration, but also avoids a reduction of production efficiency caused by too slow etching due to too low concentration. Accordingly, the etching rate is ensured to be within an appropriate range, the production efficiency is improved while quality of the CIGS solar cell is ensured. For example, the molar concentration of the potassium cyanide in the potassium cyanide solution is 0.1 mol/L.

In some embodiments of the present disclosure, the potassium cyanide solution chemically reacts with the copper, and the copper selenium compounds:

Cu+H₂O+KCN →K[Cu(CN)₂]+H₂+KOH;

Cu₂₋ₓSe+ KCN+H₂O → K[Cu(CN)₂]+K₂Se+KOH+H₂

It can be understood that, after the laminated structure is etched by the KCN solution, the copper and copper selenium compounds (mainly Cu₂₋ₓSe) on the surface of the CIGS layer 14 of the laminated structure chemically react with the KCN in the KCN solution. As such, the copper and copper selenium compounds on the surface of the CIGS layer 14 can be removed to improve photoelectric conversion performance of the CIGS solar cell and increase conversion efficiency of the solar cell. In addition, as compared with the bromine-methanol solution, the KCN solution reacts with the copper selenium compound to form a water-soluble substance, and the generated gas can be discharged into the air, and a side reactant, the simple substance Se that may affect photoelectric conversion performance of the CIGS solar cell, is not generated during the whole reaction process. Therefore, conversion efficiency of the CIGS solar cell can be better improved than adopting the bromine-methanol solution.

It is worth mentioning that, the surface of the CIGS layer 14 may be firstly etched with the bromine-methanol solution, and then further etched with the KCN solution to remove the Se single substance generated by that the bromine-methanol solution etches the surface of the CIGS layer 14, the specific principle is as follows:
First step:

   Br₂+Cu₂₋ₓSe → CuBr₂+Se;
Second step:

   Se+ Br₂ → SeBr₄;

Since the second step of the reaction is relatively slow, the simple substance Se still remains on the surface of the CIGS layer 14 after the etching time is over. In order to remove the simple substance Se, the surface of the CIGS layer after being etched with the bromine-methanol solution is further etched with the KCN solution, the specific principle is as follows:

Se+KCN → KSeCN

It can be understood that, after the surface of the CIGS layer 14 is etched with the bromine-methanol solution followed by the KCN solution, the copper selenium compound (mainly Cu₂₋ₓSe) on the surface of the CIGS layer 14 firstly chemically reacts with the bromine in the bromine-methanol solution to form CuBr₂ and SeBr₄ capable of being resolved in the bromine-methanol solution. Because of the slow reaction rate between Se and Br₂, the surface of CIGS layer 14 can be further etched with the KCN solution, so that Se and KCN chemically react. As such, the copper selenium compound on the surface of the CIGS layer 14 can be removed by using the bromine-methanol solution, the simple substance selenium formed by the reaction of the bromine-methanol and the copper selenium compound can be further removed with KCN, so as to improve photoelectric conversion performance of the CIGS solar cell and increase conversion efficiency of the solar cell.

In some embodiments of the present disclosure, specifically, the laminated structure may be washed by a cleaning machine with deionized water for cleaning ions attached thereto, followed by dried by N₂. Then, the laminated structure is annealed in an N₂ atmosphere. An annealing temperature is 150-500 °C, an annealing time is 20min∼40min. When the annealing temperature and the annealing time are within this range, it ensures that the laminated structure is dried and the CIGS layer 14 has better crystallinity. In some embodiments of the present disclosure, for example, the annealing time is 30 min, and the annealing temperature is 250 °C.

In step S103, a buffer layer 15, a window layer 16 and a transparent electrode layer 17 are sequentially formed on the surface of the annealed CIGS layer 14. In some embodiments of the present disclosure, an anti-reflection layer 18 is formed on the transparent electrode layer 17, and a top electrode 19 is formed at the anti-reflection layer 18.

Specifically, the buffer layer 15 may be deposited on the CIGS layer 14 by using a CBD (Chemical Bath Deposition) method, and the buffer layer 15 may be CdS, and a thickness of the CdS ranges from 0.03 µm to 0.08 µm, for example, a thickness of the CdS is 0.04 µm.

The window layer 16 may be formed by sputtering on the buffer layer 15 using a magnetron sputtering device. Specifically, in this embodiment, the Ar gas is used as the discharge gas, the sputtering pressure is 0.1 Pa to 1 Pa, for example, the sputtering pressure is 0.5 Pa, the radio frequency (RF) power source is adopted, and the window layer 16 is deposited on the buffer layer 15. The window layer 16 may be intrinsic zinc oxide (i-ZnO), and a thickness of the i-ZnO ranges from 0.01 µm to 0.1 µm, for example, a thickness of the i-ZnO is 0.05 µm.

The transparent conductive layer 17 may be formed by sputtering on the window layer 16 using a magnetron sputtering device. Specifically, in this embodiment, the Ar gas is used as discharge gas, the sputtering pressure is 0.5 Pa, the radio frequency (RF) power source is adopted, and the transparent conductive layer 17 is deposited on the window layer 16. The transparent conductive layer 17 may be aluminum-doped zinc oxide (AZO), a thickness of the AZO layer is in a range of 0.3 µm to 1 µm, for example, a thickness of the AZO layer is 0.6 µm.

The anti-reflection layer 18 may be formed by vapor deposition on the transparent conductive layer 17 using a vacuum evaporation device, and the anti-reflection layer 18 may be magnesium fluoride (MgF). A thickness of the anti-reflection layer 18 is in a range of 0.03 µm to 0.1 µm, for example, a thickness of the anti-reflection layer 18 is 0.05 µm. It should be noted that the anti-reflection layer 18 in some embodiments of the present disclosure may be prepared by a sputtering method other than the above-mentioned vacuum evaporation method, e.g., the magnetron sputtering method, and the process thereof is similar to the formation process of the support layer and the back electrode layer mentioned above, and in order to avoid repetition of content, details are not described herein.

Step S105, the top electrode 19 is formed at the anti-reflection layer 18.

The top electrode 19 may be formed by sputtering on the anti-reflection layer 18 using a magnetron sputtering device. Specifically, in some embodiments of the present disclosure, the Ar gas is used as discharge gas, the sputtering pressure is 0.1 Pa to 1 Pa, for example, the sputtering pressure is 0.5 Pa, a DC power source is adopted, and the top electrode 19 is deposited on the anti-reflection layer 18. The top electrode 19 may be made of Al, and a thickness of the top electrode 19 is in a range of 0.03 µm to 0.1 µm, for example, a thickness of the top electrode 19 is 0.05 µm. It should be noted that, the top electrode 19 is embedded in the anti-reflection layer 18, and the top electrode 19 is in contact with the transparent conductive layer 17.

Some embodiments of the present disclosure further relate to a CIGS solar cell 100. As shown in FIG. 2, the CIGS solar cell is prepared by adopting the preparation method of the CIGS solar cell according to the foregoing embodiments. The CIGS solar cell comprises the substrate 11 as well as the upper support layer 12, the back electrode layer 13, the CIGS layer 14, the buffer layer 15, the window layer 16, the transparent electrode layer 17, and the anti-reflection layer 18 sequentially formed on the substrate 11, meanwhile, the top electrode 19 is further formed on the anti-reflection layer 18. The CIGS solar cell provided by some embodiments of the present disclosure has better photoelectric conversion performance and higher conversion efficiency higher accordingly.

It should be understood that, these embodiments refer to structural embodiments corresponding to the foregoing embodiments, and these embodiments may be implemented in cooperation with the foregoing embodiments. The related technical details mentioned in the foregoing embodiments are still valid in these embodiments, and are not described herein again in order to avoid repetition. Accordingly, the related technical details mentioned in these embodiments may also be applied to the foregoing embodiments.

A person of ordinary skill in the art can understand that, the above respective embodiments are specific embodiments for implementing the present disclosure, and various changes may be made in form and in detail in practice without departing from scope of the present disclosure.

## Claims

1. A method for preparing a CIGS solar cell, comprising:
forming a back electrode layer and a CIGS layer sequentially on a surface of a substrate;
etching a surface of the CIGS layer, and then performing cleaning, drying and annealing treatments after the etching is completed; and
forming a buffer layer, a window layer and a transparent electrode layer sequentially on an annealed surface of the CIGS layer after annealing treatment.

2. The method for preparing the CIGS solar cell according to claim 1, wherein the step of etching the surface of the CIGS layer, and performing cleaning, drying and annealing treatments after the etching is completed comprises:
dipping a laminated structure, which comprising the substrate, the back electrode layer and the CIGS layer, into an etchant for etching; and
cleaning with deionized water, and then drying and annealing under an inert atmosphere after the etching is completed.

3. The method for preparing the CIGS solar cell according to claim 1 or 2, wherein, the surface of the CIGS layer is perpendicular to a liquid surface of the etchant during the etching process.

4. The method for preparing the CIGS solar cell according to any one of claims 1 to 3, wherein, the etchant is selected from a bromine-methanol solution and/or a potassium cyanide solution, and etching time ranges from 30s to 90s.

5. The method for preparing the CIGS solar cell according to claim 4, wherein when the etchant comprises the bromine-methanol solution, a volume ratio of bromine water to methanol in the bromine-methanol solution is 1∼10: 90∼99.

6. The method for preparing the CIGS solar cell according to claim 5, wherein when the etchant comprises the bromine-methanol solution, the volume ratio of bromine water to methanol in the bromine-methanol solution is 5: 95.

7. The method for preparing the CIGS solar cell according to claim 4, wherein when the etchant comprises the potassium cyanide solution, a molar concentration of the potassium cyanide solution ranges from 0.05 mol/L to 0.5 mol/L.

8. The method for preparing the CIGS solar cell according to claim 7, wherein when the etchant comprises the potassium cyanide solution, the molar concentration of the potassium cyanide solution is 0.1 mol/L.

9. The method for preparing the CIGS solar cell according to any one of claims 1 to 8, wherein an annealing temperature ranges from 150° C to 500° C, and an annealing time ranges from 20 min to 40 min.

10. A CIGS solar cell prepared by the method for preparing the CIGS solar cell according to any one of claims 1 to 9.
